# EUROPEAN PATENT APPLICATION

(11) **EP 1 126 285 A1**
(43) Date of publication of application: **22.08.2001**
(21) Application number: 00301013.9
(22) Date of filing: 09.02.2000
(51) Int. Cl.: G01R 33/3415

(54) **Phased array MRI RF coils**

(71) Applicant: GE YOKOGAWA MEDICAL SYSTEMS, LTD., Hino-shi, Tokyo 191 (JP)
(72) Inventor: Morita, Kensaku, Hino-shi, Tokyo 191-8503 (JP)
(74) Representative: Pedder, James Cuthbert

(57) **Abstract**

Multiple phased array coils (312,314) are used so that multiple subjects of imaging are put into the internal spaces of the loops of the coils individually, thereby receiving sensitively the magnetic resonance signals coming from the adjoining subjects.

## Description

The present invention relates to a method of magnetic resonance signal reception and an apparatus for magnetic resonance imaging. Particularly, the invention relates to a method of magnetic resonance signal reception based on phased array coils and an apparatus for magnetic resonance imaging which uses phased array coils.

A conventional magnetic resonance imaging apparatus which uses so-called phased array coils is described in U.S. Patent No.4,825,162. The phased array coil has its sensitivity of signal reception deteriorated in proportion to the distance from the coil loop to the subject of imaging, and therefore in the case of imaging the knees of a patient by using two unit coils for example, a sufficient sensitivity of signal reception cannot be obtained due to the distance between the knees and the coils resulting from the bend of knees, the presence of muscles, and the like.

The present invention seeks to provide a method of receiving magnetic resonance signals of adjoining body parts sensitively by using phased array coils and an apparatus for imaging the magnetic resonance of adjoining body parts sensitively by using phased array coils.

At a first viewpoint, the present invention resides in a method of magnetic resonance signal reception by use of a plurality of coils which form a phased array, wherein a plurality of subjects of imaging are put into the internal spaces of the loops of the coils individually, thereby receiving the magnetic resonance signals.

At a second viewpoint, the present invention resides in an apparatus for magnetic resonance imaging which includes a static magnetic field producing means for producing a static magnetic field in a space which contains a subject of imaging, a gradient magnetic field producing means for producing a gradient magnetic field in the space, a high-frequency (RF) magnetic field producing means for producing an RF magnetic field in the space, a measuring means for measuring a magnetic lesonance signal coming from the space, and an imaging means for creating an image based on the magnetic resonance signal measured by the measuring means, wherein the measuring means includes phased array coils so that a plurality of subjects of imaging are put into the internal spaces of the loops of the coils individually.

The inventive method and apparatus are designed to put multiple subjects of imaging into the internal spaces of the loops of coils individually, Thereby receiving magnetic resonance signals. The resulting smaller distances between the coil loops and the imaging subjects attain the enhanced sensitivity of signal reception.

Consequently, it becomes possible by the present invention to accomplish a method of receiving magnetic resonance signals of adjoining body parts sensitively by using phased array coils and an apparatus for imaging the magnetic resonance of adjoining body parts sensitively by using the phased array coils.

The invention will now be described in greater detail, by way of example, with reference to the drawings, in which:
Fig. 1 is a block diagram of the magnetic resonance imaging apparatus based on an embodiment of this invention;
Fig. 2 is a schematic diagram showing the receiving coil device of the apparatus shown in Fig. 1;
Fig. 3 is a schematic diagram showing the wearing of the receiving coil device shown in Fig. 2 on the subject of imaging;
Fig. 4 is a timing chart showing an example of the pulse sequence implemented by the apparatus shown in Fig. 1;
Fig. 5 is a schematic diagram showing the wearing of the receiving coil device shown in Fig. 2 on the subject of imaging; and
Fig. 6 is a schematic diagram showing the wearing of the receiving coil device shown in Fig. 2 on the subject of imaging.

Embodiments of the present invention will be explained in detail with reference to the drawings.

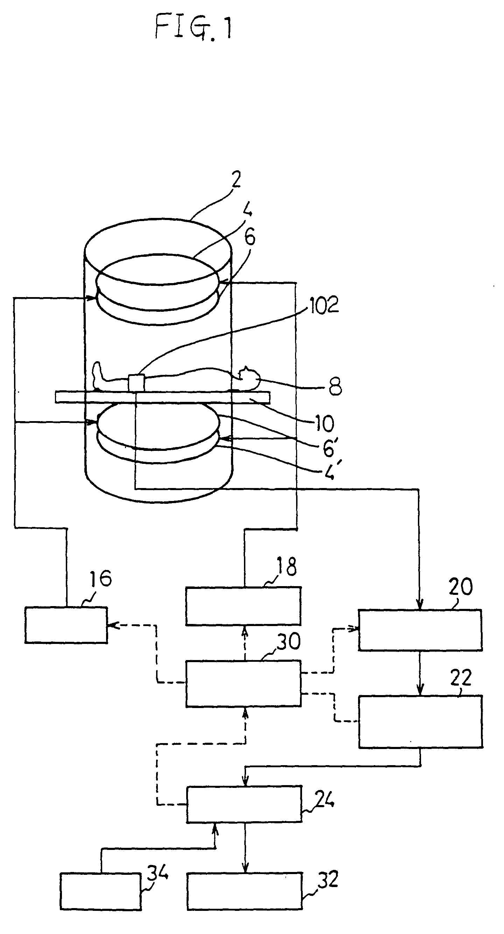

Fig. 1 shows by block diagram the magnetic resonance imaging apparatus based on this invention. The arrangement and the operation of this magnetic resonance imaging apparatus represent embodiments in terms of the apparatus and method of this invention.

In the apparatus shown in Fig. 1, a static magnetic field generator 2 produces a uniform static magnetic field in its internal space. The static magnetic field generator 2 has a pair of magnetic generation devices (not shown), such as permanent magnets, which confront each other by being spaced out in the vertical direction so that a static magnetic field (vertical magnetic field) is produced in the space between them. The magnetic generation device may be a superconduction electric magnet or an ordinary-conduction electric magnet, obviously.

Placed in the internal space of the static magnetic field generator 2 are gradient coils 4 and 4' and sending coils 6 and 6', with each coil pair confronting each other by being spaced out in the vertical direction. A subject of imaging, i.e., body of patient,8 placed on an imaging table 10 is moved by a conveyance means (not shown) into the space between the sending coils 6 and 6' so that the longitudinal axis of the subject body 8 is orthogonal to the direction of static magnetic field.

A receiving coil 102, which is an embodiment of the receiving coil device of this invention, is placed in close vicinity to the imaging portion of the subject body 8. The receiving coil 102 shown in the figure is for imaging the knees, and it is worn on the knees of the subject body 8. The detailed structure of the receiving coil 102 will be explained later.

The gradient coils 4 and 4' are connected to a gradient coil driver 18, which energizes the gradient coils 4 and 4' to produce gradient magnetic fields. The gradient magnetic fields produced include a slice gradient magnetic field, a readout gradient magnetic field, and a phase encode gradient magnetic field.

The sending coils 6 and 6' are connected to a transmitter 16, which energizes the sending coils 6 and 6' to produce an RF magnetic field which induces the spin in the knees of the subject body 8. The receiving coil 102 receives magnetic resonance signals caused by the spin in the knees of the subject body 8. The receiving coil 102 is connected to the input of a receiver 20, and the received signal is introduced to it.

The receiver 20, which is given the received signal by the receiving coil 102, has its output connected to an analog-to-digital (A/D) converter 22, which converts the output signal of the receiver 20 into digital data. The A/D converter 22 has its output connected to a computer 24.

The computer 24 stores the digital data provided by the A/D converter 22 into a memory (not shown), which forms a two-dimensional Fourier data space. The computer 24 implements the two-dimensional inverse Fourier transformation for the date of the two-dimensional Fourier data space thereby to create an image of the imaging portion of the subject body 8.

The computer 24 is connected to a controller 30, which is connected with the transmitter 16, gradient coil driver 18, receiver 20 and A/D converter 22. The controller 30 controls these devices 16,18,20 and 22 in accordance with the commands given by the computer 24, thereby implementing the magnetic resonance imaging.

The computer 24 is also connected to a display unit 32 which displays images created by the computer 24 and various information and to an operation console 34 which is used by the operator to enter instructions and information to the computer 24.

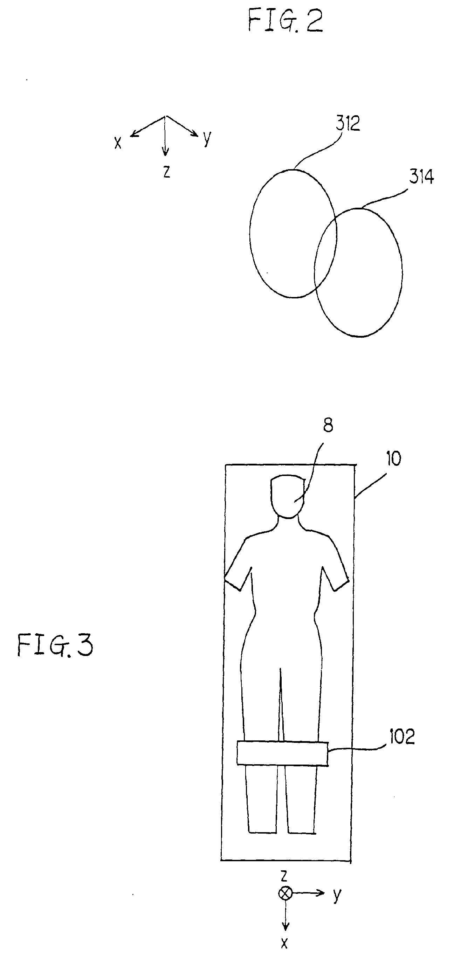

Fig. 2 shows an example of the arrangement of the receiving coil 102. In a three-dimensional space having orthogonal axes x, y and z, the subject body 8 has a longitudinal axis along the x axis. The receiving coil 102 has two coil loops 312 and 314 which lie on the y-z plane by being shifted in position in the y-axis direction. Each of the coil loops 312 and 314 is a one or multi-turn solenoid coil, and has the sensitivity of reception in the x-axis direction. The coil loops 312 and 314 overlap partially to form a so-called phased array, which is an embodiment of this invention. The provision of two coil loops 312 and 314 is an embodiment in terms of using multiple coils of this invention. The coil loops 312 and 314 are insulated electrically from each other. Each of the coil loops 312 and 314 has an associated capacitor (not shown) , so that the reception signal is led out from the electrodes of the capacitor.

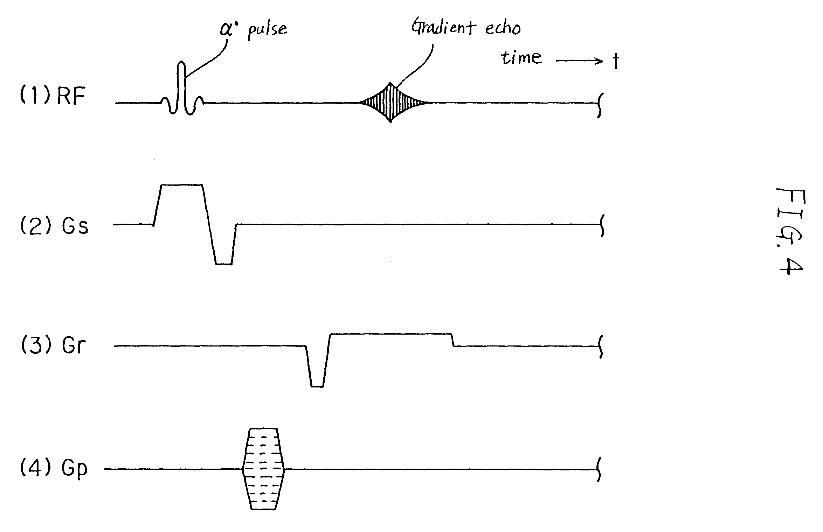

For the diagnosis of the knees of the subject body 8, the legs of the subject body 8 are put into the two coil loops 312 and 314 individually so that the coil loops 312 and 314 are located at the knees as shown in Fig. 3. Accordingly, the coil loops 312 and 314 run closely around the individual knees, enabling the high-sensitivity reception of the magnetic resonance signals arising in the knees.

Next, the operation of the foregoing magnetic resonance imaging apparatus will be explained. The subject body 8 is placed on the imaging table 10 at its retracting position (not shown), and the receiving coil 102 is worn on the subject body 8. Subsequently, the imaging table 10 is moved into the internal space of the static magnetic field generator 2. The imaging operation proceeds under control of the controller 30.

As a specific example of magnetic resonance imaging, the gradient echo scheme, among other schemes inclusive of the spin echo scheme and echo planar imaging (EPI), will be explained.

A pulse sequence as shown in Fig. 4 for example is used for the magnetic resonance imaging based on the gradient echo scheme. The pulse sequence progresses from left to right along the time axis t on the drawing under control of the controller 30.

The RF excitation by the α pulse takes place as shown by (1) in Fig. 4, with the slice gradient magnetic field Gs being applied as shown by (2) in Fig. 4. Consequently, the spin arises selectively at the intended position of the subject body 8. Following this selective excitation, the spin is rephased by the gradient magnetic field Gs.

Next, phase encoding by the phase encode gradient magnetic field Gp takes place as shown by (4) in Fig. 4. The readout gradient magnetic field Gr is applied to dephase the spin, and the polarity of gradient magnetic field is reversed to read out the magnetic resonance signal (gradient echo).

Based on the foregoing arrangement of the receiving coil 102, the magnetic resonance signals from the knees of the subject body 8 are received sensitively, and received signals with the better s/n property can be obtained.

The foregoing pulse sequence is repeated at a prescribed repetition period TR to collect gradient echoes. The phase encode gradient magnetic field Gp has its magnitude varied for each TR cycle, and data of magnetic resonance of multiple views are cumulated in the memory.

The computer 24 implements the two-dimensional inverse Fourier transformation for the data stored in the memory thereby to create tomographic images of the knees of the subject body 8. Owing to the signal reception with the better s/n property, high-quality tomographic images are produced and displayed on the display unit 32.

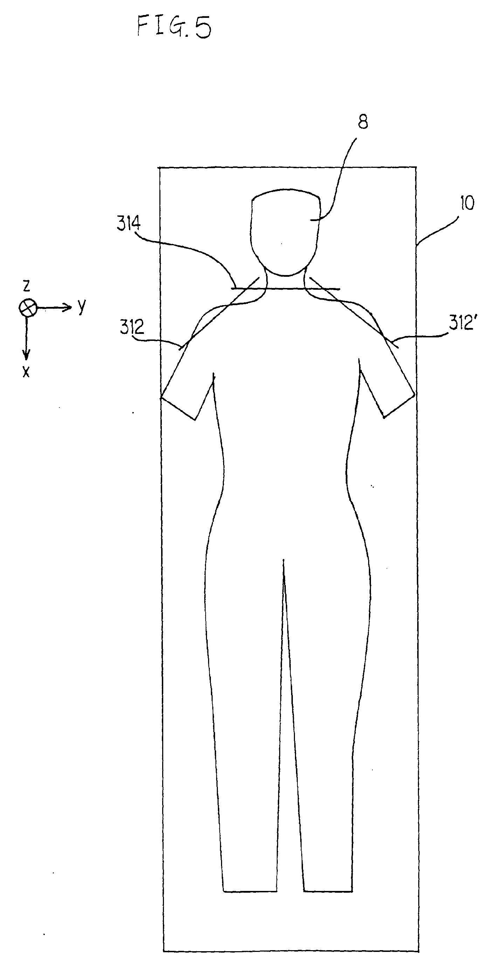

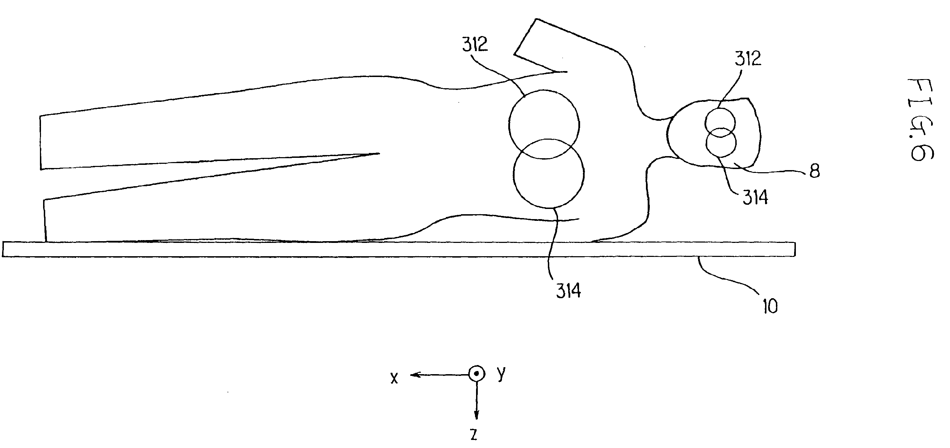

Besides the use of two phased array coils as explained above for imaging the knees, a receiving coil device made up of three phased array coils can be used to image the neck and shoulders of a patient as shown in Fig. 5, for example. Moreover, a reception coil device made up of two phased array coils can be used to image the breasts or eyes of a patient as shown in Fig. 6, for example. In any case, multiple coil loops run closely around individual imaging portions, whereby high-sensitivity signal reception can be accomplished.

## Claims

1. A method of magnetic resonance signal reception by use of a plurality of coils which form a phased array, wherein a plurality of subjects of imaging are put into the internal spaces of the loops of said coils individually, thereby receiving magnetic resonance signals.

2. A magnetic resonance signal receiving method according to claim 1, wherein said subjects of imaging are the knees of a patient to be diagnosed.

3. A magnetic resonance signal receiving method according to claim 1, wherein said subjects of imaging are the shoulders of a patient to be diagnosed.

4. A magnetic resonance signal receiving method according to claim 1, wherein said subjects of imaging include the neck of a patient to be diagnosed.

5. A magnetic resonance signal receiving method according to claim 1, wherein said subjects of imaging are the breasts of a patient to be diagnosed.

6. A magnetic resonance signal receiving method according to claim 1, wherein said subjects of imaging are the eyes of a patient to be diagnosed.

7. A magnetic resonance signal receiving method according to any preceding claim, wherein said coils comprise one-turn coils.

8. A magnetic resonance signal receiving method according to any one of claims 1 to 6, wherein said coils comprise multi-turn solenoid coils.

9. An apparatus for magnetic resonance imaging which includes static magnetic field producing means for producing a static magnetic field in a space which contains a subject of imaging; gradient magnetic field producing means for producing a gradient magnetic field in said space; high-frequency (RF) magnetic field producing means for producing an RF magnetic field in said space; measuring means for measuring a magnetic resonance signal coming from said space; and imaging means for creating an image based on the magnetic resonance signal measured by said measuring means, wherein said measuring means includes phased array coils so that a plurality of subjects of imaging are put into the internal spaces of the loops of said coils individually.

10. A magnetic resonance imaging apparatus according to claim 9, wherein said subjects of imaging are the knees of a patient to be diagnosed.

11. A magnetic resonance imaging apparatus according to claim 9, wherein said subjects of imaging are the shoulders of a patient to be diagnosed.

12. A magnetic resonance imaging apparatus according to claim 9, wherein said subjects of imaging include the neck of a patient to be diagnosed.

13. A magnetic resonance imaging apparatus according to claim 9, wherein said subjects of imaging are the breasts of a patient to be diagnosed.

14. A magnetic resonance imaging apparatus according to claim 9, wherein said subjects of imaging are the eyes of a patient to be diagnosed.

15. A magnetic resonance imaging apparatus according to any one of claims 9 to 14, wherein said coils comprise one-turn coils.

16. A magnetic resonance imaging apparatus according to any one of claims 9 to 14, wherein said coils comprise multi-turn solenoid coils.
